# EUROPÄISCHE PATENTSCHRIFT

(11) **EP 1 281 304 B1**
(45) Veröffentlichungstag und Bekanntmachung des Hinweises auf die Patenterteilung: **04.08.2004**
(21) Anmeldenummer: 01940162.9
(22) Anmeldetag: 18.04.2001
(51) Int. Cl.: H05K 7/20

(54) **EINE ELEKTRONISCHE STEUERBAUGRUPPE FÜR EIN FAHRZEUG**
ELECTRONIC CONTROL MODULE FOR A VEHICLE
GROUPE DE COMMANDE ELECTRONIQUE POUR UN VEHICULE

(30) Priorität: 04.05.2000 AU PQ729400
(43) Veröffentlichungstag der Anmeldung: 05.02.2003
(73) Patentinhaber: ROBERT BOSCH GMBH, 70442 Stuttgart (DE)
(72) Erfinder: SPASEVKSI, Blagoj, Doncaster, VIC 3108 (AU); TARQUINIO, Vincent, Bulleen, VIC 3105 (AU)
(86) Internationale Anmeldenummer: PCT/DE2001/001491
(87) Internationale Veröffentlichungsnummer: WO 2001/084898

(56) Entgegenhaltungen:
- WO-A-98/36628
- GB-A- 2 270 207
- US-A- 4 575 578

## Beschreibung

Die vorliegende Erfindung bezieht sich auf eine elektronische Steuerbaugruppe für ein Fahrzeug.

Bei der Herstellung von Fahrzeugteilen wird auf Kosteneinsparungen strengste Rücksicht genommen, da jeder Pfennig, der bei einem Teil eingespart wird, in der Massenproduktion von Fahrzeugen natürlich von großer Bedeutung ist Eines der mit Steuerbaugruppen für Fahrzeugelektronik verbundenen Probleme ist, daß zusätzlich zu einer Fertigungskostenminderung noch die Anforderung besteht, daß diese Teile äußerst robust sein müssen, um den verschiedensten Umgebungsbedingungen widerstehen zu können, einschließlich großen Temperaturschwankungen und verschiedenen Stoß- und Vibrationspegeln. Die Baugruppen müssen ausreichend abgedichtet und ihre elektrischen Komponenten gegen eine große Reihe von Betriebsbedingungen verbunden mit verschiedenen Umweltbedingungen geschützt werden. Es wird hiermit angestrebt, die obigen Schwierigkeiten zu meistern und zumindest eine zweckmäßige Alternative zu elektronischen Steuerbaugruppen-Konfigurationen gemäß dem gegenwärtigen Stand der Technik bereitzustellen.

Die erfindungsgemäße elektronische Steuerbaugruppe hat:
eine gedruckte Schaltkarte (PCB) mit mindestens einer elektronischen Komponente und mindestens einem Wärmeableitmittel für die mindestens eine elektronische Komponente; und
ein Gehäuse mit einem Bauteil, das thermisch mit dem Wärmeableitmittel verbunden ist;
wobei sie eine thermisch leitende Abdichtung für das Gehäuse einschließt, wobei die Abdichtung mit dem Wärmeableitmittel und dem Bauteil thermisch verbunden ist wobei die Abdichtung nur mit Teilen der PCB verbunden ist, die Kühlung benötigen und/oder wobei die Abdichtung ausgeschnitten oder profiliert wird, um Komponente oder Teile der PCB zu vermeiden, die keine Kühlung benötigen.

Bevorzugterweise besteht die Abdichtung aus einem Material auf Silizium- und Aluminium-Oxid-Basis.

Bevorzugterweise schließt das Wärmeableitmittel Elemente wie z.B. Wärmesenken, Leiterbahnen und/oder Kontaktbereiche ein.

Das betreffende Bauteil kann eine Deckplatte oder eine Grundplatte des Gehäuses sein, die aus Metall gefertigt ist, und der übrige Teil des Gehäuses kann aus einem Kunststoffmaterial hergestellt sein.

Bevorzugte Ausführungen der vorliegenden Erfindung werden nachfolgend nur beispielsweise mit Bezug auf die beiliegenden Zeichnungen beschrieben:
Figur 1 ist eine auseinandergezogene perspektivische Darstellung einer bevorzugten Realisierung einer elektronischen Steuerbaugruppe;
Figur 2 ist eine zweite auseinandergezogene perspektivische Darstellung der elektronischen Steuerbaugruppe;
Figur 3 ist eine perspektivische Ansicht eines thermischen Dämpfungsglieds einer elektronischen Steuerbaugruppe;
Figur 4 ist ein Querschnitt der elektronischen Steuerbaugruppe; und
Figur 5 ist ein Querschnitt einer weiteren bevorzugten Realisierung der elektronischen Steuerbaugruppe.

Eine elektronische Steuerbaugruppe 2, wie in den Figuren gezeigt, umfaßt ein Kunststoffgehäuse 4, eine beidseitig gedruckte Schaltkarte (PCB) 6, eine Metalldeckplatte 10 und ein thermisches Dämpfungsglied 8. Das Dämpfungsglied 8 ist ein thermisch leitendes, elektrisch isolierendes Dämpfungsglied auf Silizium-Basis. Das Dämpfungsglied wird als Schnittstellen-Material zwischen der PCB 6 und der Deckplatte 10 verwendet und bietet gleichzeitig niedrigwertigen thermischen Widerstand gegenüber Wärmefluß aufgrund von Stromwärmeverlust seitens Komponenten der PCB 6. Das Dämpfungsglied 8 dient als eine Abdichtung zwischen dem Gehäuse 4 und der Deckplatte 10. Das Dämpfungsglied 8 stellt auch folgendes bereit:
(i) eine niedrigwertige Wärmewiderstands-Verbindung zwischen den Wärmeleitkomponenten der PCB und der Deckplatte 10;
(ii) elektrische Trennung der elektronischen Komponenten der PCB und der Deckplatte 10;
(iii) Spannungsentlastung für die elektronischen Komponenten der elektronischen Steuerbaugruppe während eventueller mechanischer oder thermischer Schocks; und
(iv) eine Abdichtung zwischen der Deckplatte 10 und dem Gehäuse 4.

Das Dämpfungsglied 8 besteht aus einem Material auf Silizium-Basis und enthält bevorzugterweise Silizium und Aluminiumoxid.

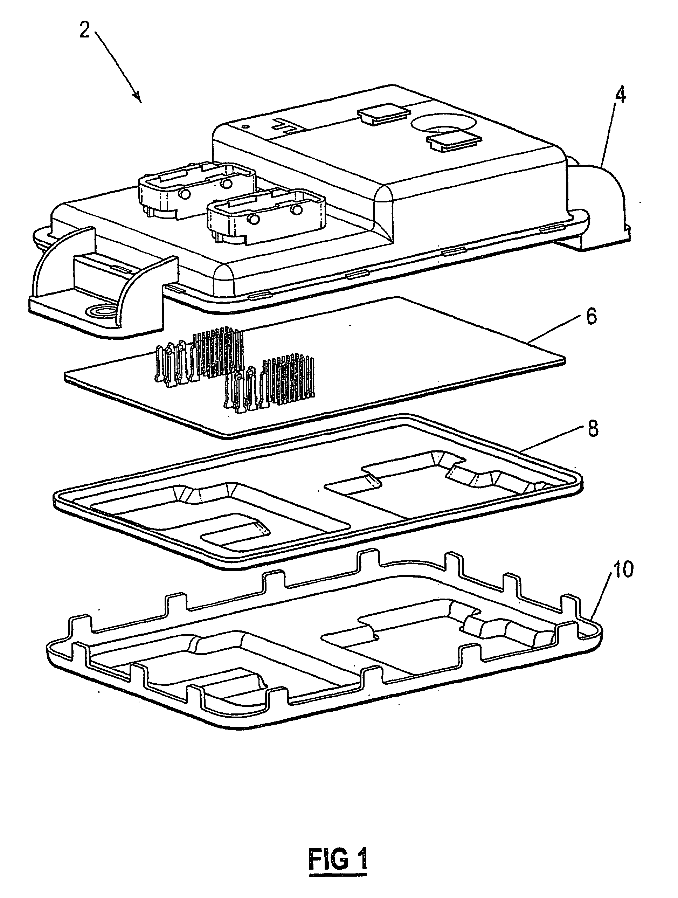

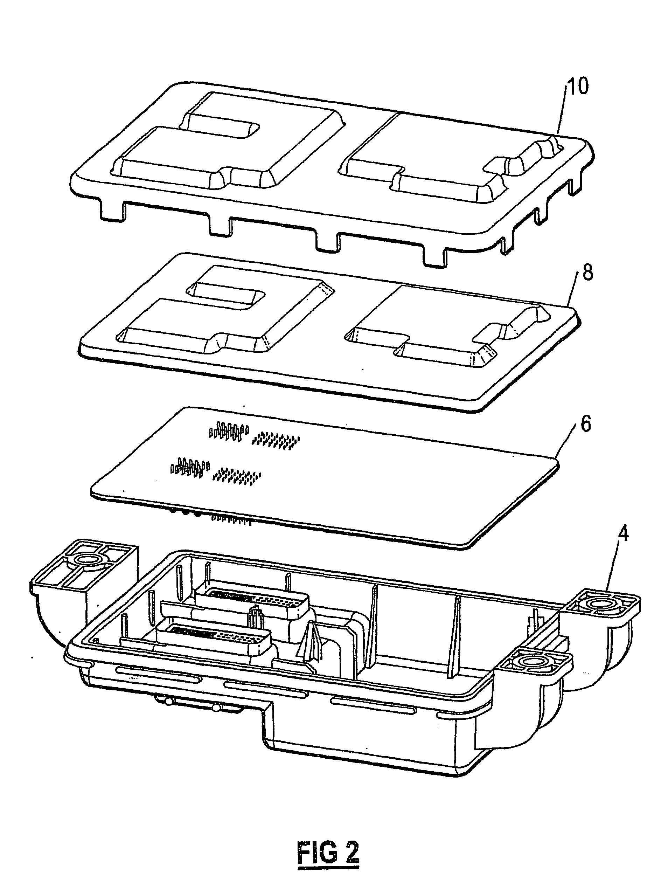

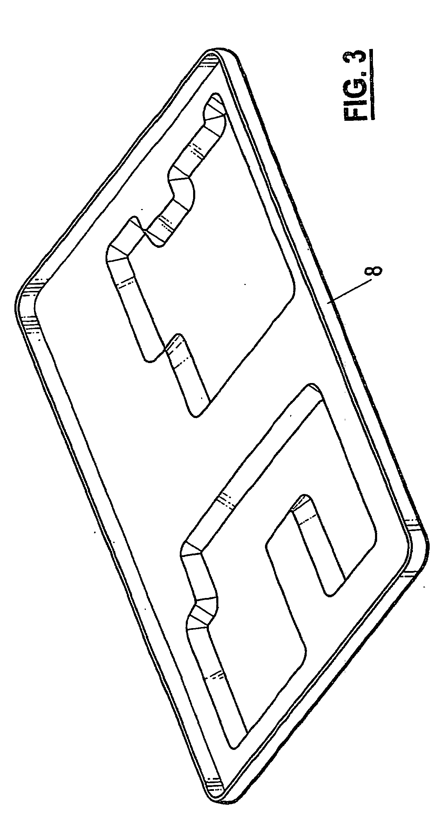

Für die in den Figuren 1 bis 4 gezeigten Ausführungen ist das Dämpfungsglied 8 so geformt, daß es der Form der Deckplatte 10 entspricht und bündig an dieser anliegt. Das Dämpfungsglied 8 ist in direkter Berührung mit der PCB 6 und ist insbesondere in Kontakt mit Teilen der PCB 6, die dazu dienen, Wärme abzuführen. Zum Beispiel umfaßt die PCB 6 Halbleiterchip-Komponente 12,13 und 15 mit daran befestigten Wärmeableitelementen 14, z.B. Wärmesenken. Für diejenigen der Komponente 12 und 15, die Kühlung benötigen, muß das Dämpfungsglied 8 mit den Elementen 14 verbunden sein, wohingegen für diejenigen der Komponente 13, die keine Kühlung benötigen, das Dämpfungsglied 8 so geformt sein kann, daß es die betreffenden Komponenten freigibt und nicht berührt. Zusätzlich, oder alternativ, können auch Wärmeableitelemente benutzt werden, die mit Leiterbahnen oder Kontakten der PCB verbunden sind und Wärmestrom von diesen empfangen und die von den Komponenten getrennt sind.

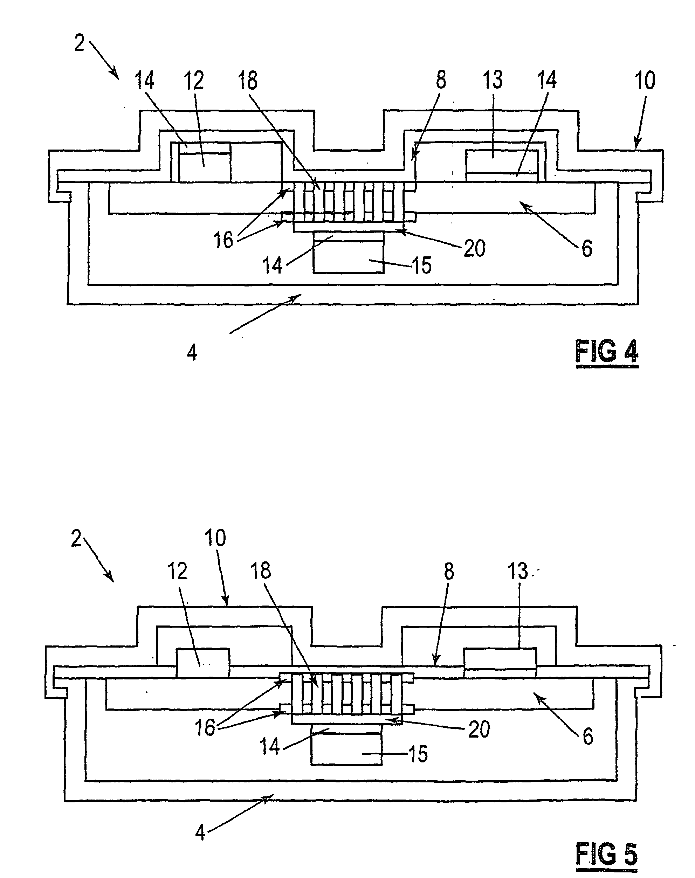

Die gedruckte Schaltkarte 6 umfaßt verzinnte Kupfer-(Cu)-Dämpfungsglieder 16 an entgegengesetzten Seiten der PCB 6, die durch verzinnte thermische Durchgangsleitungen oder Leitungen 18 durch die PCB 6 verbunden sind. Die Wärmesenke 14 einer elektrischen Komponente 15 kann dann mit einem der Kupfer-Dämpfungsglieder 16 durch einen großen Lötkontakt 20 verbunden werden. Das Kupfer-Dämpfungsglied 16 an der gegenüberliegenden Seite der PCB 6 ist mit dem thermischen Dämpfungsglied 8, wie in Figuren 4 und 5 gezeigt, verbunden. Diese Konfiguration bietet eine wesentliche Verbesserung der Wärmeableitung von der mit dem Lötkontakt 20 verbundenen Komponenten 15. Insbesondere die thermischen Durchgangsleitungen 18 verbessern wesentlich den Wärmestrom von den ableitenden Komponenten 14 und 20 an das thermische Dämpfungsglied 8.

Für die Ausführung gemäß Figur 5 wird das Dämpfungsglied 8 anstatt der Form der Deckplatte 10 zu entsprechen so geschnitten, daß es sich um die elektrische Komponente 12 und 13 erstreckt und auf der Seite der PCB 6 angrenzend an die Deckplatte 10 liegt. Die wärmeabführenden Elemente 14 der Komponenten 13, die Kühlung benötigen, sind mit dem thermischen Dämpfungsglied 8 verbunden oder an dieses angrenzend, wohingegen Komponenten 12, die keine Kühlung benötigen, nicht mit dem Dämpfungsglied 8 verbunden sind.

Eine Vielzahl von Abwandlungen werden dem Fachmann gegenwärtig sein, ohne daß das Wesentliche und der Umfang der mit Bezug auf die beiliegenden Zeichnungen beschriebenen Erfindung überschritten wird.

## Patentansprüche

1. Eine elektronische Steuerbaugruppe (2) mit:
einer gedruckten Schaltkarte (PCB)(6) mit mindestens einer elektronischen Komponente (12,15) und mindestens einem Wärmeableitmittel (14,20) für die mindestens eine elektronische Komponente; und
einem Gehäuse (4,10) mit einem Bauteil (10), das thermisch mit dem Wärmeableitmittel (14) verbunden ist; wobei
sie eine thermisch leitende Abdichtung (8) für das Gehäuse (4,10) einschließt, wobei die Abdichtung (8) mit dem Wärmeableitmittel (14,20) und dem Bauteil (10) thermisch verbunden ist,
wobei die Abdichtung (8) nur mit Teilen (12,14,15,20) der PCB verbunden ist, die Kühlung benötigen. und/oder
wobei die Abdichtung (8) ausgeschnitten oder profiliert wird, um Komponente oder Teile (13) der PCB zu vermeiden, die keine Kühlung benötigen.

2. Eine elektronische Steuerbaugruppe (2) gemäß Anspruch 1, wobei die Abdichtung (8) aus einem Material auf Silizium- und Aluminium-Oxid-Basis besteht.

3. Eine elektronische Steuerbaugruppe gemäß Anspruch 1, wobei das Wärmeableitmittel (14,20) Elemente wie z.B. Wärmesenken, Leiterbahnen und/oder Kontaktbereiche einschließt

4. Eine elektronische Steuerbaugruppe gemäß Anspruch 1, wobei das Bauteil (10) eine Deckplatte oder eine Grundplatte des Gehäuses (4,10) ist und aus Metall gefertigt ist

5. Eine elektronische Steuerbaugruppe gemäß Anspruch 4, wobei der übrige Teil (4) des Gehäuses (4,10) aus einem Kunststoffmaterial hergestellt ist

## Claims

1. An electronic control module (2), having:
a printed circuit board (PCB)(6) having at least one electronic component (12, 15) and at least one means (14, 20) for conducting away heat for the at least one electronic component; and
a housing (4, 10) with a part (10) which is thermally connected to the means (14) for conducting away heat;
said electronic control module (2) including a thermally conductive seal (8) for the housing (4, 10), the seal (8) being thermally connected to the means (14, 20) for conducting away heat and to the part (10),
the seal (8) being connected only to parts (12, 14, 15, 20) of the PCB which require cooling and/or the seal (8) being blanked out or contoured in order to avoid components or parts (13) of the PCB which do not require cooling.

2. An electronic control module (2) according to Claim 1, the seal (8) being composed of a material on a silicon and aluminium oxide basis.

3. An electronic control module according to Claim 1, the means (14, 20) for conducting away heat including elements such as, for example, heat sinks, conductor tracks and/or contact regions.

4. An electronic control module according to Claim 1, the component (10) being a cover plate or a base plate of the housing (4, 10) and being fabricated from metal.

5. An electronic control module according to Claim 4, the rest (4) of the housing (4, 10) being manufactured from a plastic material.

## Revendications

1. Groupe de commande électronique (2) comprenant :
une carte de circuits imprimés PCB (6) comprenant au moins un composant électronique (12, 15) et au moins un moyen de dissipation de chaleur (14, 20) pour l'au moins un composant électronique, et
un boîtier (4, 10) comprenant un composant (10) qui est relié thermiquement avec le moyen de dissipation de chaleur (14),
dans lequel une garniture d'étanchéité (8) à conductibilité thermique pour le boîtier (4, 10), est incluse en étant thermiquement reliée avec le moyen de dissipation de chaleur (14, 20) et le composant (10),
la garniture d'étanchéité (8) est reliée seulement avec les pièces (12, 14, 15, 20) de la carte de circuits imprimés PCB qui nécessitent un refroidissement, et
la garniture d'étanchéité (8) est découpée ou profilée de façon à éviter les composants ou pièces (13) de la carte de circuits imprimés PCB qui ne nécessitent pas de refroidissement.

2. Groupe de commande électronique (2) selon la revendication 1,
**caractérisé en ce que**
la garniture d'étanchéité (8) est constituée d'un matériau à base d'oxyde de silicium et d'aluminium.

3. Groupe de commande électronique selon la revendication 1,
**caractérisé en ce que**
le moyen de dissipation de chaleur (14, 20) inclut des éléments tels que, par exemple, puits thermiques, pistes conductrices et/ou zones de contact.

4. Groupe de commande électronique selon la revendication 1,
**caractérisé en ce que**
le composant (10) est une plaque de recouvrement ou une plaque de base du boîtier (4, 10) et est fabriqué en métal.

5. Groupe de commande électronique selon la revendication 4,
**caractérisé en ce que**
l'autre pièce (4) du boîtier (4, 10) est fabriqué en un matériau en matière plastique.
